# EUROPEAN PATENT APPLICATION

(11) **EP 1 215 953 A1**
(43) Date of publication of application: **19.06.2002**
(21) Application number: 00127609.6
(22) Date of filing: 16.12.2000
(51) Int. Cl.: H05K 13/04

(54) **Device for securing components**

(71) Applicant: Grundig AG, 90471 Nürnberg (DE)
(72) Inventor: Crump, Paul, Mid Glamorgan, South Wales CF39 8UA (GB)

(57) **Abstract**

The present invention relates to a device for securing components.

The present invention describes a device for securing components, having means for converting a longitudinal movement into a rotational movement and a twisting tool attached to the converting means, whereby the position of the device is not altered during the twisting tool is rotated by the converting means.

It is the advantage of the present invention to allow components to be secured without the need of twisting lugs or terminals of the components, avoiding strains on operators wrists and repetitive strain injuries caused otherwise by securing components manually. As the position of the device including the twisting tool is not altered during the process of fixing components, i. e. during the conversion of the longitudinal movement into a rotational movement, the device can be handled easily.

## Description

The present invention relates to a device for securing components.

For the production of electronic goods usually components like electronic components are mounted to printed circuit boards, and terminals and lugs of the electronic components are plugged into bore or punch holes. After all electronic components have been mounted onto the printed circuit board, the components are soldered to the printed circuit board, e. g. by flow soldering. If bigger electronic components, e. g. tuners or modulators, are used for production it is necessary to secure these components to the printed circuit board in order to keep them at their correct positions during the soldering process and to give additional strength to them.

So far components are secured to the printed circuit board by using a pair of pliers or a small hand tool to twist the lugs or terminals of the components jutting out at the backside of the circuit board to which the components have been mounted. By twisting the lugs or terminals at the backside of the printed circuit board the lugs or terminals are canted in the bore or punch holes and are secured in that way to the printed circuit board.

The known method of securing components to printed circuit boards has the disadvantage that operators which have to mount thousands of components during one shift may hurt their wrists over a long period of time because of repetitive strain injuries. In addition to that, it has shown that the process of twisting can also cause damage to the components, as the lugs or terminals may be torn off if twisted too hard.

Therefore there is a need to provide a device for securing components, without the necessity of manually twisting the lugs or terminals of the components in order to secure them.

The present invention addresses these objectives by a device for securing components, having means for converting a longitudinal movement into a rotational movement and a twisting tool attached to the converting means, whereby the device remains at its position during the tool is rotated by the converting means.

It is the advantage of the present invention to allow components to be secured without the need of twisting lugs or terminals of the components manually, avoiding strains on operators wrists and repetitive strain injuries caused otherwise by securing components manually. As the position of the device including the twisting tool is not altered during the process of fixing components, i. e. during the conversion of the longitudinal movement into a rotational movement, the device can be handled easily.

In accordance with the present invention the means for converting the longitudinal movement into a rotational movement is a helix system.

The use of a helix system for converting a longitudinal movement into a rotational movement allows a very cheap and simple construction to be utilised.

In a further aspect of the invention the helix system is constructed such that the rotational movement is limited, especially limited to an angle of 90 degree.

The limitation of the rotational movement allows to secure the components to the circuit board without damaging the components.

Further advantages will be seen from the following description, by way of example only, with reference to the accompanying drawings which only show elements important for the understanding of the present invention and in which:
- Fig. 1: is a sectional drawing of an embodiment of a device for securing components,
- Fig. 2: is a replaceable tool bit, as shown in Fig. 1,
- Fig. 3: is a first part of a helix system, as shown in Fig. 1,
- Fig. 4: is a second part of the helix system, as shown in Fig. 1,
- Fig. 5: is a third part of the helix system, as shown in Fig. 1,
- Fig. 6: is front spacer element for attaching the helix system to a means for generating a longitudinal movement, as shown in Fig. 1,
- Fig. 7: is a holder element for attaching a shaft to a means for generating a longitudinal movement, as shown in Fig. 1,
- Fig. 8: is a handle element for the device for securing components, as shown in Fig. 1, and
- Fig. 9: is the shaft for attaching the handle element to the device for securing components, as shown in Fig. 1.

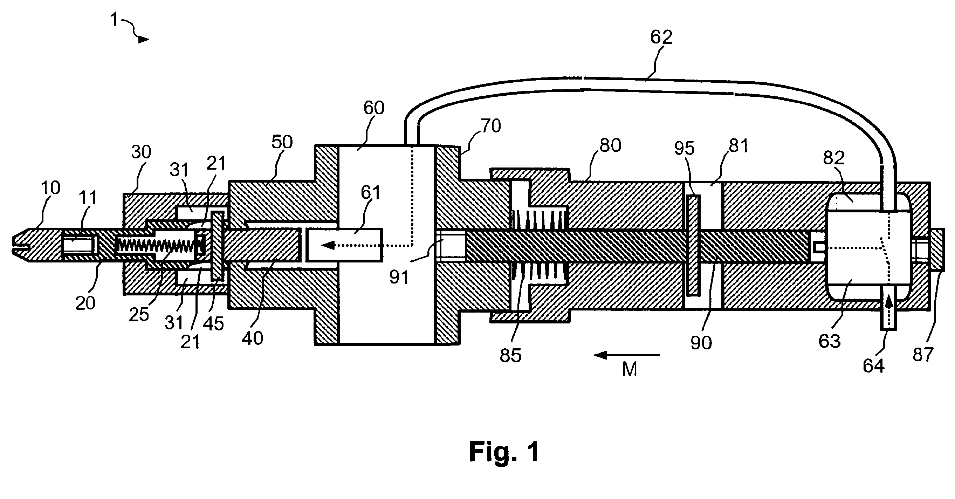

Fig. 1 shows a sectional drawing of an embodiment of a device for securing components, particularly to printed circuit boards.

The device 1 comprises a twisting tool 10, means for converting a longitudinal movement into a rotational movement 20, 25, 30, 40, 45, 50, means for generating a longitudinal movement 60 and a handle 70, 80, 85, 90, 95. The means for converting a longitudinal movement into a rotational movement 20, 25, 30, 40, 45, 50, the means for generating a longitudinal movement 60 and the handle 70, 80, 85, 90, 95 are assembled with screws.

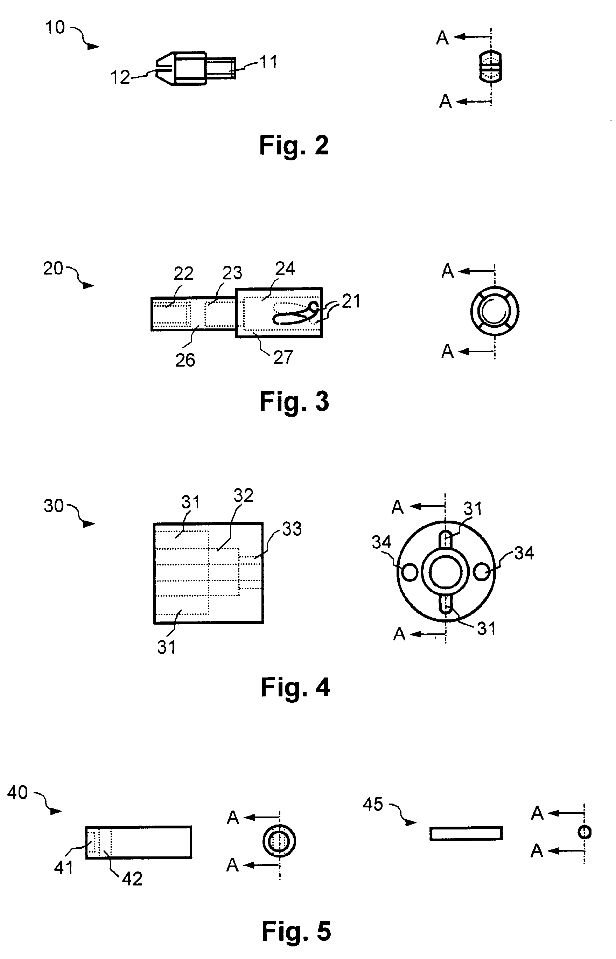

The twisting tool 10 is shown in more detail in Fig. 2. It is formed by a replacement tool bit 10 having a slotted tip 12 and a thread section 11. The twisting tool 10 may be made of steel and may be produced by using a lathe. The twisting tool 10 or parts of it, particularly the slotted tip 12, may be hardened. Direction AA shows the sectional view as depicted in Fig. 1.

The converting means 20, 25, 30, 40, 45, 50 for converting a longitudinal movement into a rotational movement in this embodiment is formed by a helix system and is shown in Fig. 3 to 6.

Fig. 3 shows as a first part of the converting means an inner core 20. The inner core 20 has a first section 26 having a smaller diameter than the diameter of its second section 27. At the top of the first section 26 is a thread section 22 adapted for the thread section 11 of twisting tool 10. The second section 27 has a bore hole 24, 23 which extends into the first section 26. The bore hole 24, 23 has a first section 24 having a greater diameter than a second section 23 which extends into the first section 26 of the inner core 20. The second section 27 of the inner core 20 has two helical recesses 21 being situated 180 degree apart from each other and having opposite pitch. The bore holes 23, 24 and the thread section 22 are situated along the rotational axis of the inner core 20. The inner core 20 may be made of steel and may be produced by using a lathe. The inner core 20 or parts of it, particularly the second section 27 having the helical recesses 21, may be hardened. Direction AA shows the sectional view as depicted in Fig. 1.

Fig. 4 shows as a second part of the converting means an outer part 30. The outer part 30 has a first bore hole 33 having a diameter essentially equal to the diameter of the first section 26 of the inner core 20. A second bore hole 32 is adjoining the first bore hole 33 having a diameter adapted to house the second section 27 of the inner core 20. Its length is essentially equal to the length of the second section 27 of the inner core 20. The diameter and the length of the second bore hole 32 allow the inner core 20 to be rotated when it is put in the outer part 30. The two bore holes 32, 32 are situated along the rotational axis of the outer part 30. Two slots 31 being separated by 180 degree are situated along the second bore hole 32. The length of the slots 31 is essentially equal to the dimension of the helical recesses 21 of the second section 27 of the inner core 20. The outer part 30 in addition has two bore holes 34, separated by 180 degree, for mounting the outer part 30, as will be described later. The outer part 30 may be made of steel and may be produced by using a lathe. Direction AA shows the sectional view as depicted in Fig. 1.

Fig. 5 shows as a third part of the converting means a sleeve 40 and a pin 45. The sleeve 40 has a bore hole 42, being anti-parallel to the rotational axis of the sleeve 40, adapted for the pin 45. A recess 41 at the one end of the sleeve 40 close to bore hole 42 is adapted to hold a spring as will be described later. The sleeve 40 and the pin 45 may be made of steel. Direction AA shows the sectional view as depicted in Fig. 1.

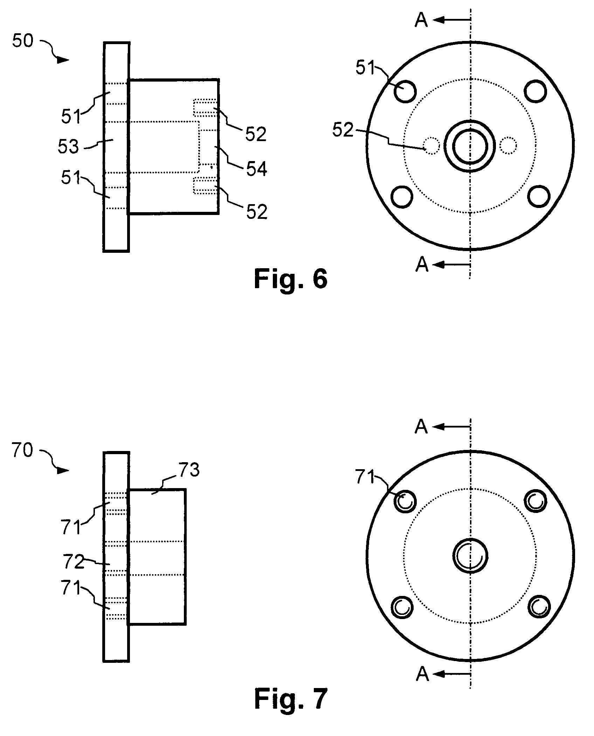

Fig. 6 shows a front spacer element 50 for attaching the converting means to the means for generating a longitudinal movement 60, as shown in Fig. 1.

At the one end the front spacer element 50 has four bore holes 51 for attaching it to the means for generating a longitudinal movement 60. At the other end the front spacer element 50 has two bore holes 52 having threads adapted for attaching the outer part 30 of the converting means to the front spacer element 50 using screws put through bore holes 34 of the outer part 30. Along the rotational axis of the front spacer element 50 a bore hole 53, 54 is situated. The bore hole 53, 54 is adapted for the sleeve 40 (section depicted by numeral 54) and for a piston 61 of the means for generating a longitudinal movement 60 (section depicted by numeral 53). The front spacer element 50 may be made of aluminium and may be produced by using a lathe. Direction AA shows the sectional view as depicted in Fig. 1.

The handle 70, 80, 85, 90, 95 for using the device 1 is shown in Fig. 7 to 9.

Fig. 7 shows a holder element 70 for attaching a shaft 90 to the means for generating a longitudinal movement 60, as shown in Fig. 1. The holder element 70 has at its one end four bore holes 71 with threads for attaching the holder element 70 to the means for generating a longitudinal movement 60. At the other end a part 73 is adapted for attaching a handle element 80. Along the rotational axis of the holder element 70 a bore hole 72 is situated. The bore hole 72 has a thread for attaching the shaft 90. The front holder element 70 may be made of aluminium and may be produced by using a lathe. Direction AA shows the sectional view as depicted in Fig. 1.

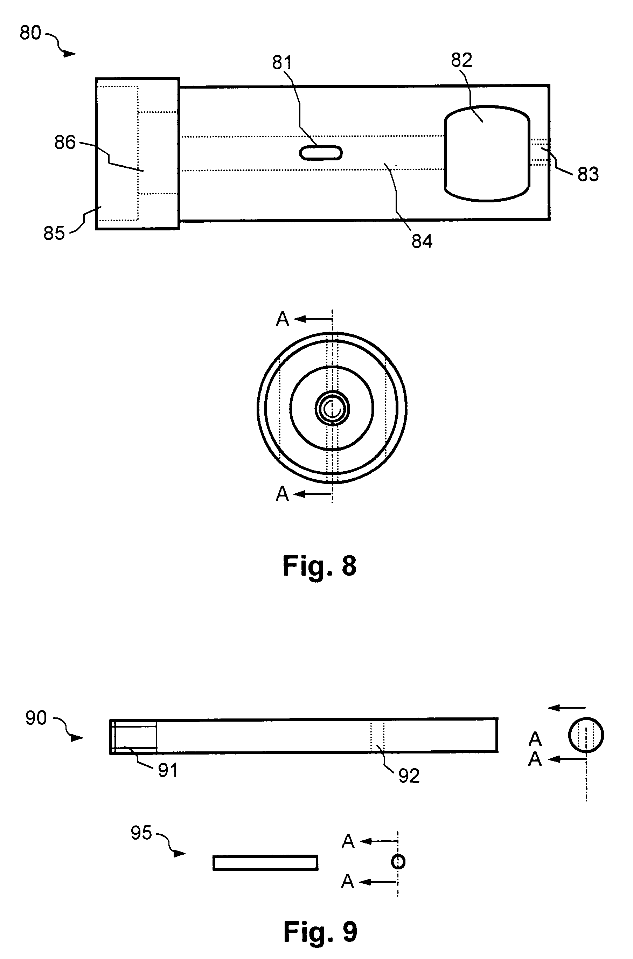

Fig. 8 shows the handle element 80 having bore holes 85, 86, 84, 83, all situated along the rotational axis of the handle element 80. Bore hole 85 is adapted for part 73 of the holder element 70. The concatenated bore hole 86 is adapted for a spring 85, which use will be described later. The bore hole 84 concatenated to bore hole 86 is adapted for shaft 90. A slot 81 is adapted for a pin 95 to fix the shaft 90.

The handle element 80 in addition has a recess 82 for accommodating an activator 63, whose use will be described later. A bore hole 83 with a thread is used for fixing the activator with a screw 87. The handle element 80 may be made of aluminium and may be produced by using a lathe. Direction AA shows the sectional view as depicted in Fig. 1.

Fig. 9 shows shaft 90 and pin 95. The shaft 90 has a bore hole 92, being anti-parallel to the rotational axis of the shaft 90, adapted for the pin 95. A thread 91 at the one end of the shaft 90 is adapted for attaching the shaft 90 to the tread 72 of the holder element 70. The shaft 90 and the pin 95 may be made of steel. Direction AA shows the sectional view as depicted in Fig. 1.

For assembling the device 1 the front spacer element 50 and the holder element 70 are placed to the front and back side of the means for generating a longitudinal movement 60. Four screws, not shown, are used to fix the front spacer element 50 and the holder element 70 through the bore holes 51 of the front spacer element 50 and the threads 71 of the holder element 70.

For the handle 70, 80, 85, 90, 95 of the device 1, the shaft 90 is fixed with its thread 91 to the thread 72 of the holder element 70. A spring 85 is put over the shaft 90 and the handle element 80 is put on the shaft 90. The handle element 80 is pressed in a direction depicted by arrow M against the force of the spring 85 and pin 95 is inserted via the recess 81 of shaft 80 into bore hole 92 of shaft 90.

After inserting pin 95 the handle element 80 can be moved against the force of spring 85 towards direction M for a distance determined by recess 81. Spring 85 will return the handle element 80 to its starting position after it is released. In that way the activator 63 fixed in recess 82 of the handle element 80 by screw 87 can be activated by moving the handle element 80 towards direction M.

In the depicted embodiment, the activator 63 is part of a pneumatic or hydraulic system and is used as a switch for pressure 64 in the pneumatic or hydraulic system. The pressure 64 is guided via the activator 63 and a flexible pipe 62 to the means for generating a longitudinal movement 60, which may be a known pneumatic or hydraulic component. The longitudinal movement is then generated by a piston 61 which is moved by pressure 64.

The assembly of the means for converting a longitudinal movement into a rotational movement 20, 25, 30, 40, 45, 50 will be described now. At first a spring 25 is put into the bore hole 23, 24 of the inner core 20. The recess 41 of sleeve 40 is then put onto the end of spring 25 projecting over the inner core 20 and pushed inside bore hole 24. The sleeve 40 is adjusted to a position where bore hole 42 is accessible through the helical recesses 21. At this position pin 45 is inserted through the helical recesses 21 of the inner core 20 into bore hole 42 of sleeve 40.

The end of sleeve 40 projecting over the inner core 20 is then inserted into bore hole 54 of the front spacer 50. After the inner core 20 is positioned in that way, the outer part 30 is put over the inner core 20, whereby the slots 31 of the outer part 30 receive the ends of pin 45, which is put - as described above - through the helical recesses 21 of the inner core 20 and bore hole 42 of the sleeve 40. The outer core 30, which now rests upon the front spacer 50 is rotated to a position where the threads 52 of the front spacer 50 are accessible through bore holes 34 of the outer core 30. The outer core 30 is then fixed to the front spacer 50 by tow screws not shown.

Finally the twisting tool 10 is fixed, by screwing its thread 11 into the thread 22 of the inner core 20.

Now the operation of the device 1 for securing components will be described.

After a component has been mounted to a circuit board lugs or terminals of the components jutting out of bore or punch holes at the backside of the circuit board. These lugs or terminals are twisted using the device 1 for securing the component. For this purpose the slotted tip of the twisting tool 11 is positioned in a way at the backside of the printed circuit board that a lug or a terminal of the component is inside the slot 12. By a defined rotation of the twisting tool 11, which will be described afterwards, the lug or terminal is canted in the bore or punch hole and is thereby secured to the printed circuit board.

The rotational movement of the twisting tool 11 is started by pressing the handle element 80 against the force of spring 85 towards the holder element 70 (direction M). Thereby the fixed shaft 90 actuates the activator 63 and pressure 64 is guided via the activator 63 and the flexible pipe 62 to the hydraulic or pneumatic component 60, the piston 61 of which produces a longitudinal movement.

The longitudinal movement of the piston 61 is transmitted to sleeve 40 which moves in a longitudinal direction into the bore hole 24 of the inner core 20, against the force of spring 25. As the movement of the sleeve 20 is fixed by pin 45, which is guided by slots 31 of the outer part 30, only a longitudinal movement of sleeve 40 is possible. As the inner core 20 is fixed by the outer part 30 towards the longitudinal direction, because the diameter and length of the second part 27 of the inner core 20 are essentially equal to the depth and diameter of bore hole 32 of the outer part 30 (described above), only a rotational movement of the inner core 20 is possible. This rotational movement is caused by pin 45 as it slides down the helical recesses 21 of the inner core 20, forcing the inner core 20 to rotate as it is fixed as described above. The rotational movement of the inner core 20 then is transmitted to the twisting tool 10 for twisting the lug or terminal. In addition, as the inner core 20 is fixed by the outer part 30 towards the longitudinal direction, the position of the device 1 is not altered during the complete twisting process, which makes the twisting process comfortable and secure, because the risk that the twisting tool 10 is slipping off the lug or terminal is minimised.

After the twisting of the lug or terminal the device 1 is removed and the handle element 80 is released. Spring 85 then forces the handle element 80 back to its starting position, thereby interrupting activator 63 and pressure 64. In the absence of pressure 64 piston 61 is forced back to its starting position by spring 25 via sleeve 40. As sleeve 40 moves backwards in a longitudinal direction the inner core 20 and with it twisting tool 10 are rotated back to their starting position by pin 45 sliding along the helical recesses 21.

The amount of the rotational movement of the inner core 20 can be determined in particular by forming the helical recesses 21 of the inner core 20, if the amount of longitudinal movement generated by piston 61 is sufficient. In one embodiment the shape of the helical recesses 21, determined by the length and the angle of the helical recesses 21, allows a rotational movement of 90 degree. It has shown that twisting lugs or terminals of components by a rotational movement limited to 90 degree is advantageous, as this doesn't cause damage to the lugs, terminals or components.

It will be understood of the foregoing explanations that the device 1 for securing components, even it only has been explained with regard to securing electronic components to printed circuit boards, is also useful for all applications where components have to be fixed by twisting lugs or terminals.

It will also be understood from the foregoing explanations that the device 1 for securing components is also useful for all applications having a need for a defined twist, i. e. a rotational movement of a given angle.

## Claims

1. Device for securing components, **characterised by**
means for converting a longitudinal movement into a rotational movement (20, 25, 30, 40, 45, 50) and
a twisting tool (10) attached to the converting means (20, 25, 30, 40, 45, 50), whereby the device (1) remains at its position during the twisting tool (10) is rotated by the converting means (20, 25, 30, 40, 45, 50).

2. The device of claim 1,
**characterised in, that**
the converting means (20, 25, 30, 40, 45, 50) comprises an inner core (20) having helical recesses (21), a sleeve (40) moving towards the longitudinal direction, being movable attached to the helical recesses (21) of the inner core (20) with a pin (45), and an outer part (30) fixing the inner core (20) towards the direction of the longitudinal movement and the sleeve (40) towards a rotational direction, thereby only allowing a rotational movement of the inner core (20).

3. The device of claim 1 or 2,
**characterised in, that**
the helical recesses (21) of the inner core (20) cause a limitation of the rotational movement of the inner core (20).

4. The device of claim 3,
**characterised in, that**
the rotational movement of the inner core (20) is limited to 90 degree.

5. The device of one of the claims 1 to 4,
**characterised in, that**
a pneumatic or hydraulic component (60) is used for generating the longitudinal movement.

6. The device of one of the claims 1 to 5,
**characterised in, that**
a handle (70, 80, 85, 90, 95) is attached to the device (1) for handling the device (1) and for activating of the device (1) by pushing the handle (70, 80, 85, 90, 95).

7. The device of claim 6,
**characterised in, that**
the device is deactivated after the handle (70, 80, 85, 90, 95) is released.

8. The device of claim 7,
**characterised in, that**
an spring (25) returns the sleeve (40) and the inner core (20) to their starting positions, after the device (1) is deactivated.

9. The device of one of the claims 1 to 8,
**characterised in, that**
the twisting tool (10) has a slotted and hardened tip.

10. The device of one of the claims 1 to 9,
**characterised in, that**
the twisting tool (10) is replaceable.

11. The device of one of the claims 1 to 10,
**characterised in, that**
the device (10) is used for securing components to a printed circuit board.

12. The device of claim 3 or 4,
**characterised in, that**
the device (1) is used for generating a limited rotational movement or a rotational movement of a given angle.
